# EUROPEAN PATENT APPLICATION

(11) **EP 4 742 839 A1**
(43) Date of publication of application: **13.05.2026**
(21) Application number: 25155321.0
(22) Date of filing: 31.01.2025
(51) Int. Cl.: H05K 1/02, H01L 23/40, H01L 23/367, H05K 1/18, H01L 23/495

(54) **ELECTRONIC ASSEMBLY**

(30) Priority: 08.11.2024 TW 113142999
(71) Applicant: Everlight Electronics Co., Ltd., New Taipei City 238018 (TW)
(72) Inventor: LIAO, WEI SHENG, New Taipei City, R.O.C. (TW); WANG, YUNG CHENG, New Taipei City, R.O.C. (TW)
(74) Representative: dompatent

(57) **Abstract**

An electronic assembly (10, 10a) including a circuit board (100, 100a), a power chip (200, 200a) and a heat sink (300). The power chip is disposed on the circuit board and has a first surface (231) facing away from the circuit board. The heat sink includes a cooling fin (310) and a joint part (320). The cooling fin has a second surface (311) thermally coupled to the first surface (231). Area of the second surface (311) is equal to or greater than area of the first surface (231), ensuring full contact between the entire first surface and the second surface. The power chip (200, 200a) is positioned between the cooling fin (310) and the circuit board (100, 100a). The joint part (320) has an end secured to the cooling fin (310) and the other end secured to the circuit board (100, 100a).

## Description

### Technical Field

The disclosure relates to an electronic assembly, more particularly to an electronic assembly including at least one power chip.

### Background

Power chip is a Metal-Oxide-Semiconductor Field-Effect Transistor (MOSFET) processing high-power voltage and current, and is commonly applied in an electronic assembly related to power control. Recently, with the rapid development of the semiconductor technology, the amount of heat generated by the power chip is significantly increased with the performance of the power chip.

In a conventional electronic assembly, the direction along which the power chip is installed is limited, thereby reducing the flexibility for assembling the power chip and the heat sink. A screw is usually required to be disposed through the heat sink to fix the same to the power chip, which hinders the effective dissipation of the heat accumulated on the power chip due to the reduced contact area between the power chip and the heat sink. As a result, the heat dissipation efficiency of the power chip is limited, and the environment of high temperature adversely affect the performance of the power chip. In addition, such design occupies large space and thus is disadvantageous for the manufacturer to perform related arrangements and operations.

### SUMMARY

The disclosure provides an electronic assembly that can effectively dissipate the heat accumulated on the power chip to prevent the performance of the single power chip from being reduced.

One embodiment of this disclosure provides an electronic assembly including a circuit board, a power chip and a heat sink. The power chip is disposed on the circuit board and has a first surface facing away from the circuit board. The heat sink includes a cooling fin and at least one joint part. The cooling fin includes a second surface thermally coupled to the first surface. An area of the second surface is equal to or greater than an area of the first surface, ensuring full contact between the entire first surface and the second surface. The power chip is positioned between the cooling fin and the circuit board. At least one joint part has an end secured to the cooling fin and the other end secured to the circuit board.

According to the electronic assembly disclosed by above embodiments, since the first surface faces away from the circuit board, the space above the power chip may be used to arrange the heat sink in a flexible manner. Accordingly, the heat sink having suitable configuration may be used to cool the power chip based on the demand for the heat dissipation in a focused manner, thereby preventing the performance of the power chip from being reduced.

In addition, the joint part has an end secured to the cooling fin and the other end secured to the circuit board, so as to mount the cooling fin on the circuit board instead of on the power chip. Thus, it is not required to have a mounting hole on the power chip for mounting the cooling fin, thereby allowing the area of the second surface to be equal to or greater than the area of the first surface, ensuring full contact between the entire first surface and the second surface. In this way, the contact area between the first surface and the second surface is enlarged, thereby further ensuring the heat generated by the power chip to be effectively dissipated by the heat sink.

### BRIEF DESCRIPTION OF THE DRAWINGS

The present disclosure will become better understood from the detailed description given herein below and the accompanying drawings which are given by way of illustration only and thus are not intending to limit the present disclosure and wherein:
FIG. 1 is a perspective view of an electronic assembly according to a first embodiment of the disclosure;
FIG. 2 is an exploded view of the electronic assembly in FIG. 1;
FIG. 3 is a rear view of the electronic assembly in FIG. 1;
FIGS. 4 to 7 show a cooling effect of the electronic assembly in FIG. 1; and
FIG. 8 is a rear view of an electronic assembly according to a second embodiment of the disclosure.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

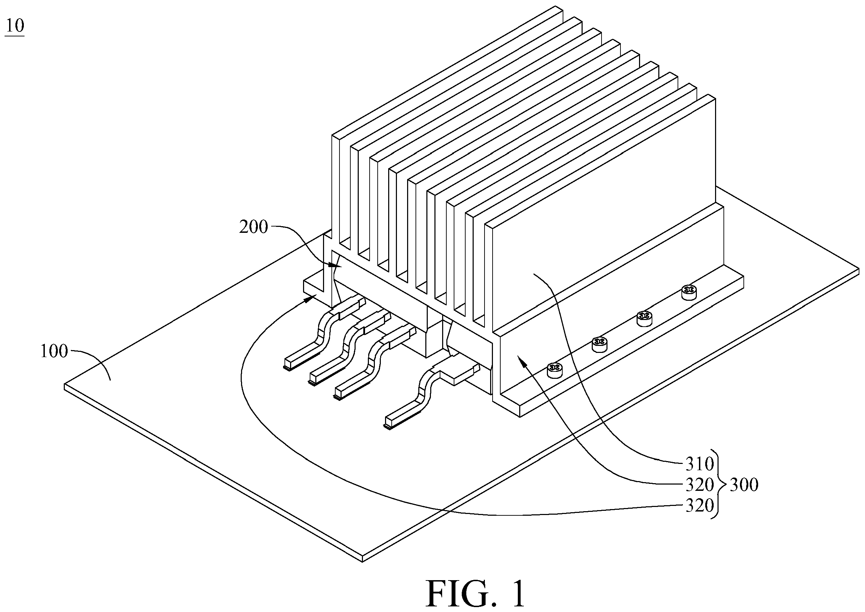

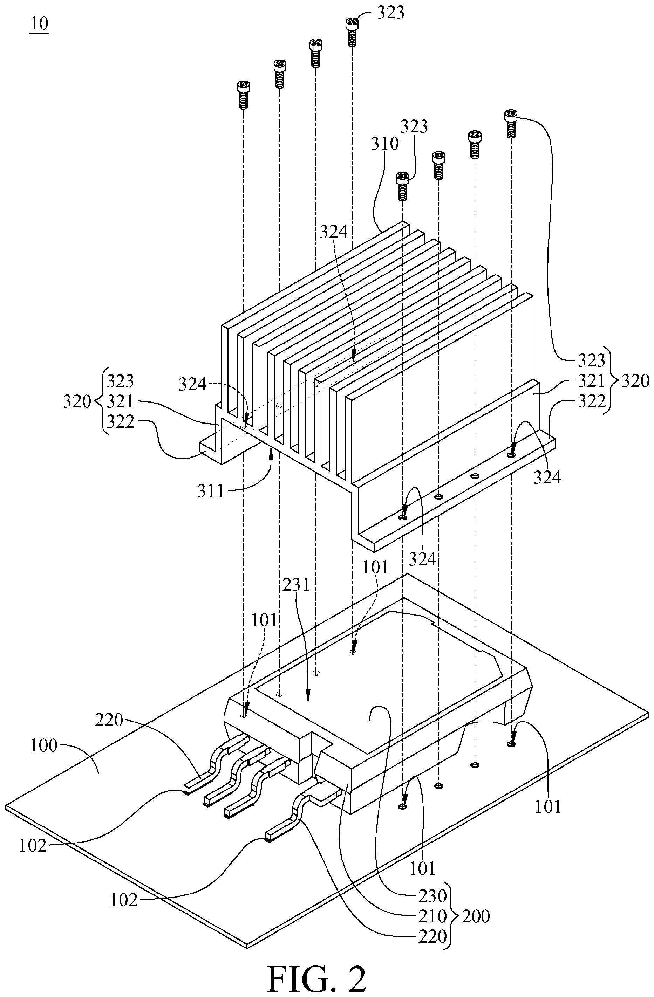

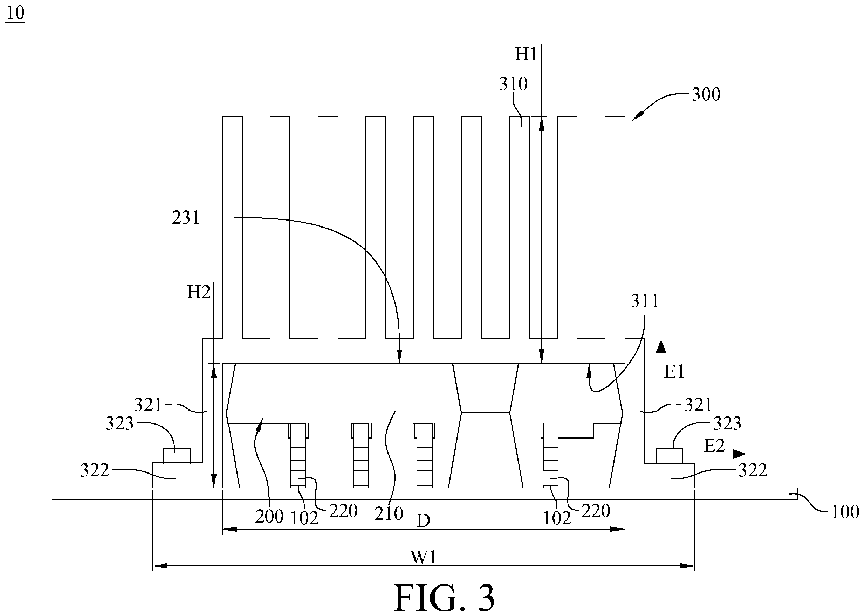

Please refer to FIGS. 1 to 3. FIG. 1 is a perspective view of an electronic assembly 10 according to a first embodiment of the disclosure. FIG. 2 is an exploded view of the electronic assembly 10 in FIG. 1. FIG. 3 is a rear view of the electronic assembly 10 in FIG. 1.

In this embodiment, for example, the electronic assembly 10 is a power module, and includes a circuit board 100, a power chip 200 and a heat sink 300. For example, the electronic assembly 10 may be applied in an automotive electronic product, such as a charging pile, an AC/DC converter, an automotive fan or other similar high-power device. Alternatively, the electronic assembly 10 may be applied in an industrial fan and an industrial generator or other similar high-power device.

The power chip 200 meets, for example, TO-247 configuration. The power chip 200 is disposed on the circuit board 100. In detail, the power chip 200 includes, for example, a chip body 210, a plurality of leads 220 and a heat dissipation sheet 230. The leads 220 protrude from an identical side of the chip body 210. The leads 220 are mounted on and electrically connected to a plurality of pads 102 of the circuit board 100 via surface-mount technology (SMT), respectively. The heat dissipation sheet 230 is disposed on the chip body 210 and has a first surface 231. The first surface 231 faces away from the circuit board 100.

Since the leads 220 protrude from an identical side of the chip body 210, the leads 220 are prevented from mismatching with one another when the circuit board 100 is deformed after being heated. Thus, the power chip 200 is prevented from being damaged.

In this embodiment, the heat sink 300 includes, for example, a cooling fin 310 and two joint parts 320. An overall width W1 of the heat sink 300 may range from 20 millimeters (mm) to 30 mm, such as 20.71 mm. The cooling fin 310 includes a second surface 311 thermally coupled to the first surface 231. In this disclosure, two components being thermally coupled denotes that the two components are in thermal contact with each other or heat can be transferred between the two components via one or more intermediate components. In addition, the area of the second surface 311 is equal to or greater than the area of the first surface 231, ensuring full contact between the entire first surface 231 and the second surface 311. The power chip 200 is positioned between the cooling fin 310 and the circuit board 100. A height H1 of the cooling fin 310 is, for example, 10 mm. Each joint part 320 has an end secured to the cooling fin 310 and the other end secured to the circuit board 100. In a preferred embodiment, the cooling fin 310 may be designed to be a metal sheet structure whose height H1 is 0.

In this embodiment, the two joint parts 320 each include, for example, a connecting part 321, a mounted part 322 and a plurality of fastened parts 323. The connecting part 321 connects the cooling fin 310 and the mounted part 322. An extension direction E1 of the connecting part 321 and an extension direction E2 of the mounted part 322 are non-parallel to each other (e.g., perpendicular to each other). An overall height H2 of the joint part 320 may range from 5 mm to 30 mm, and may be adjusted to be, for example, 5.02 mm according to the thickness of the power chip 200. The mounted part 322 has, for example, a plurality of fastening holes 324 spaced apart from one another. The fastened parts 323 are fastened into the fastening holes 324 and a plurality of fastening holes 101 of the circuit board 100, respectively. That is, the mounted part 322 is fixed to the circuit board 100 via, for example, the fastened parts 323. For example, the fastened parts 323 are screws, and the fastening holes 324 are screw holes. The fastening holes 101 of the circuit board 100 are, for example, screw holes, and may be screw holes of a metal component (not shown) embedded in the circuit board 100.

Comparing to the heat sink clamping the side edge of the circuit board, the heat sink 300 is installed on the circuit board 100 by the fastened parts 323 to have larger area for heat dissipation, thereby reaching the desired heat dissipation capacity by the heat sink 300 of small volume. In addition, the heat sink 300 is mounted on the circuit board 100 by the fastened parts 323, and thus is not limited to be mounted near the side edge of the circuit board 100. In this way, the circuit layout of the circuit board 100 is not limited. That is, the heat sink 300 is mounted on the circuit board 100 by the fastened parts 323, and thus the heat sink 300 is allowed to have small volume without reducing the flexibility for designing the circuit board 100.

Since the first surface 231 faces away from the circuit board 100, the space above the power chip 200 may be used to arrange the heat sink 300 in a flexible manner. Accordingly, the heat sink 300 having suitable configuration may be used to cool the power chip 200 based on the demand for the heat dissipation in a focused manner, thereby preventing the performance of the power chip 200 from being reduced.

In addition, joint part 320 has an end secured to the cooling fin 310 and the other end secured to the circuit board 100, so as to mount the cooling fin 310 on the circuit board 100 instead of on the power chip 200. Thus, it is not required to have a mounting hole on the power chip 200 for mounting the cooling fin 310, thereby allowing the area of the second surface 311 to be equal to or greater than the area of the first surface 231, ensuring full contact between the entire first surface 231 and the second surface 311. In this way, the contact area between the first surface 231 and the second surface 311 is enlarged, thereby further ensuring the heat generated by the power chip 200 to be effectively dissipated by the heat sink 300.

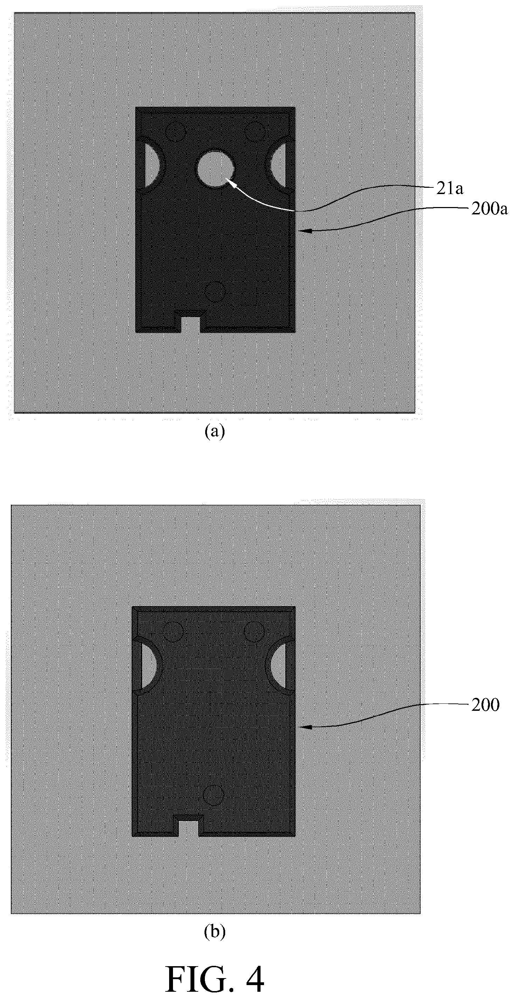

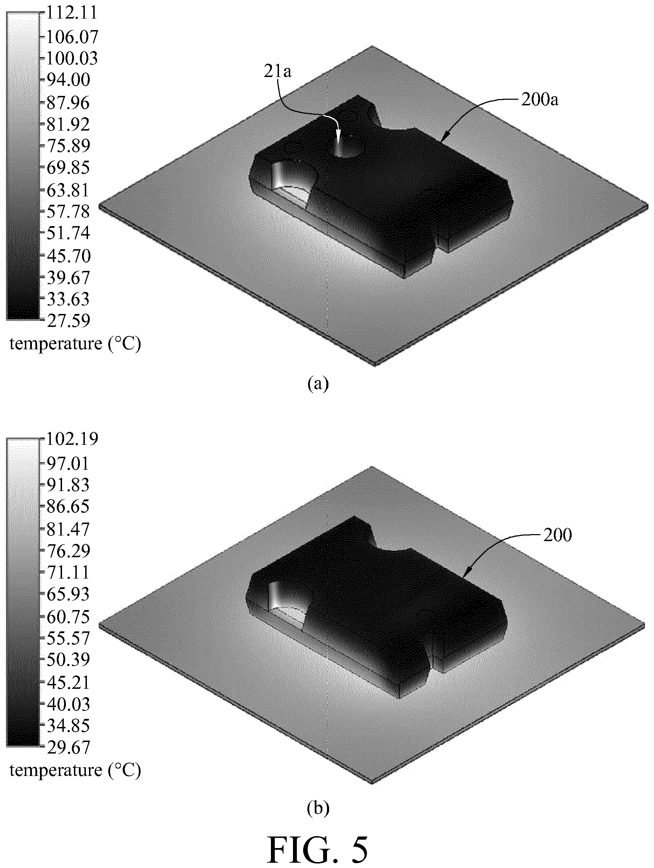

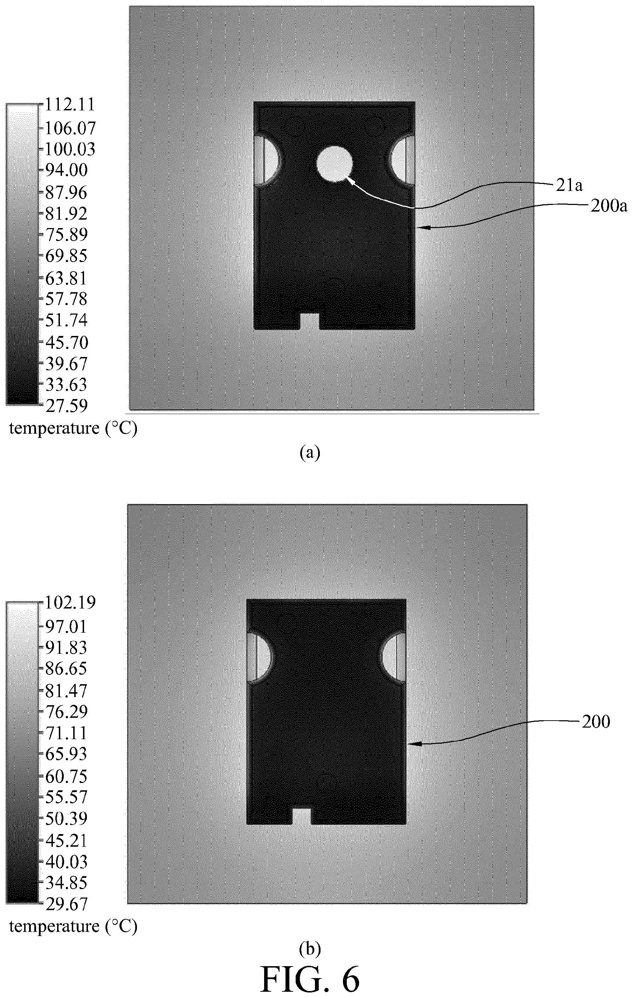

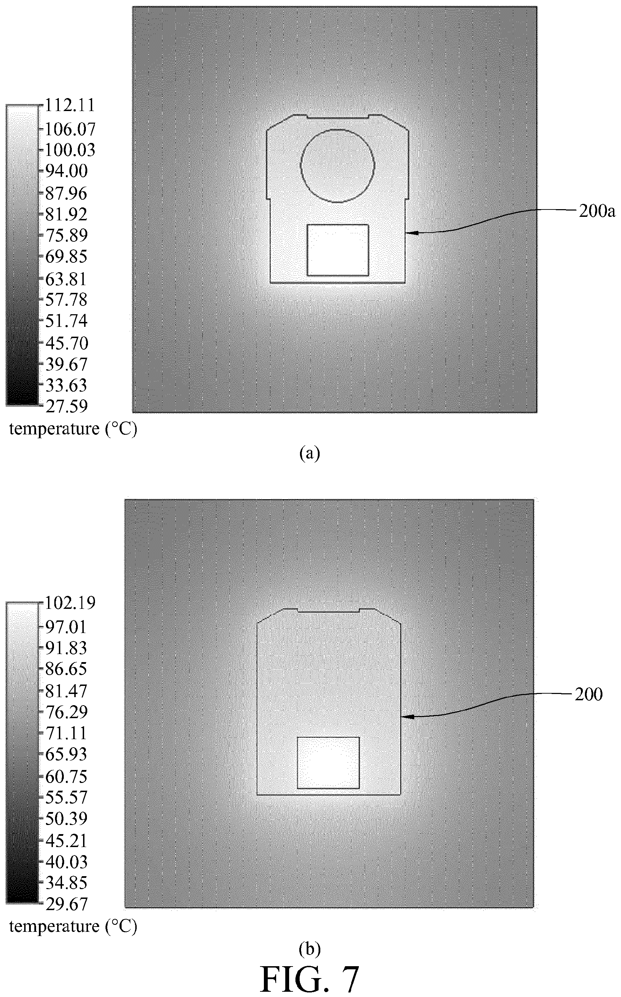

Specifically, please refer to FIG. 2 and FIGS. 4 to 7. FIGS. 4 to 7 show a cooling effect of the electronic assembly 10 in FIG. 1. In FIG. 4, the part (a) shows a power chip 200a according to another embodiment that has a mounting hole 21a for a screw (not shown) to be disposed therethrough (the mounting hole 21a is disposed through the heat dissipation sheet of the power chip 200a), and the part (b) shows the power chip 200 according to the first embodiment. In FIGS. 5 to 7, the part (a) shows the temperature distribution of the power chip 200a of the another embodiment during operation, and the part (b) shows the temperature distribution of the power chip 200 of the first embodiment during operation. As shown by the simulation results in FIGS. 5 to 7, comparing to the power chip 200a having the mounting hole 21a for the screw to be disposed therethrough, the heat dissipation sheet 230 of the disclosure without the mounting hole 21a allows the area of the first surface 231 to be increased by at least 20% (e.g., increased form 190 mm² to 230 mm²). In this embodiment, as shown in FIGS. 5 to 7, the operating temperature of the power chip 200 is decreased from 112.11 °C to 102.19 °C. That is, the heat dissipation sheet 230 without the mounting hole 21a allows the heat dissipation capacity of the cooling fin 310 to be increased by about 10%. Further, as shown in FIG. 7, with regard to the heat dissipation around the bottom part, the distributing range of the high temperature region of the power chip 200 is reduced comparing to that of the power chip 200a. The high temperature region of the power chip 200 merely distribute around the heat source in a concentrate manner, and other part of heat are transferred to the peripheral region uniformly. In this way, the desired heat dissipation capacity can be reached by the heat sink 300 of small volume, allowing the volume of the electronic assembly 10 to be reduced.

Furthermore, since the performance of the power chip 200 is not limited or reduced, the desired performance is allowed to be achieved by one power chip 200 without using two or more power chips 200. Thus, the overall volume and weight and thus the manufacture cost of the electronic assembly 10 including the power chip 200 are allowed to be reduced. Further, comparing to the electronic assembly achieving the desired performance by two or more power chips, the volume of the electronic assembly 10 according to the disclosure is reduced by about 25%, which meets the trend of miniaturization of the electronic products and enhances the flexibility of space utilization thereof.

Also, conventional power chip is in the type of dual in-line package (DIP) and thus has a heat dissipation surface facing the circuit board. In contrary, the power chip 200 of the disclosure has the first surface 231 facing away from the circuit board 100 and thus is allowed to be mounted to the circuit board 100 by SMT, thereby saving the time for assembling the power chip 200 and the circuit board 100 and facilitating the assembly of the same.

Note that the disclosure is not limited by the number of the fastened parts 323. In other embodiments, the joint part may each include one fastened part, and the mounted part and the circuit board may correspondingly each have one fastening hole. In addition, in other embodiments, the joint part may not include the fastened parts, and may be welded or soldered to the circuit board; in such embodiments, the mounted part and the circuit board may not have the fastening holes.

Moreover, the two connecting parts 321 of the two joint parts 320 are respectively connected to two opposite sides of the cooling fin 310. The chip body 210 is, for example, positioned between the two connecting parts 321. A distance D between the two connecting parts 321 may range from 15 mm to 25 mm (e.g., 15.94 mm). Note that the disclosure is not limited by the number of the joint parts 320. In other embodiments, there may be one joint part, as long as the joint part can firmly mount the cooling fin to the circuit board.

Other embodiments are described below for illustrative purposes.

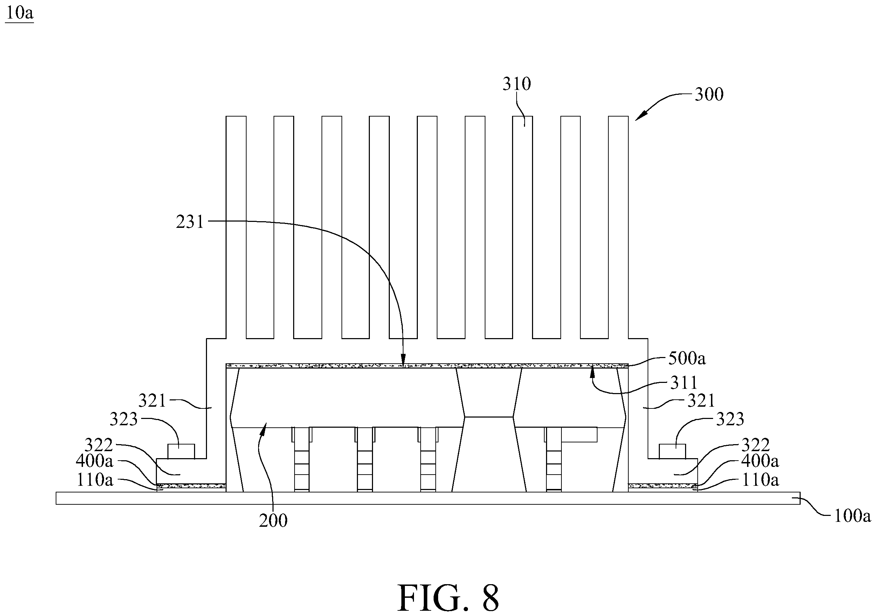

Please refer to FIG. 8. FIG. 8 is a rear view of an electronic assembly 10a according to a second embodiment of the disclosure. In this embodiment, the electronic assembly 10a includes a circuit board 100a, the power chip 200, the heat sink 300, two thermally conductive components 400a and a thermally conductive component 500a. The detailed structure of the power chip 200 and the heat sink 300 can be understood by referring to the related descriptions of the first embodiment, and thus the repeated descriptions are omitted. The main difference between the electronic assembly 10a of this embodiment and the electronic assembly 10 of the first embodiment is in that: the electronic assembly 10a of this embodiment further includes two thermally conductive components 400a and the thermally conductive component 500a, and the circuit board 100a of this embodiment further has two thermally conductive layers 110a. The thermally conductive layers 110a may, for example, thermally coupled to an external heat sink. In detail, the two mounted parts 322 of the two joint parts 320 are thermally coupled to the two thermally conductive layers 110a of the circuit board 100a via the two thermally conductive components 400a, respectively. In addition, the thermally conductive component 400a is, for example, a thermal paste, and is positioned between the mounted part 322 and the circuit board 100a. The thermally conductive component 500a is thermally coupled to the first surface 231 and the second surface 311. In addition, the thermally conductive component 500a is, for example, a thermal paste, and is positioned between the first surface 231 and the second surface 311. For example, the thermally conductive components 400a and 500a may each be a thermal paste made by silicone, polyurethane (PU), polyacrylate polymer, pressure sensitive adhesive (PSA) and the like.

The thermally conductive components 400a and the thermally conductive layers 110a provide an additional heat dissipation path for the heat sink 300. That is, besides the cooling fin 310, the heat sink 300 may also dissipate the heat by transferring it to the thermally conductive layers 110a of the circuit board 100 via the thermally conductive components 400a, which more effectively cools the power chip 200.

The thermally conductive component 500a further improves the heat transferring efficiency between the first surface 231 and the second surface 311, which allows the heat sink 300 to more effectively cool the power chip 200.

Since the first surface faces away from the circuit board, the space above the power chip may be used to arrange the heat sink in a flexible manner. Accordingly, the heat sink having suitable configuration may be used to cool the power chip based on the demand for the heat dissipation in a focused manner, thereby preventing the performance of the power chip from being reduced.

In addition, the joint part has an end secured to the cooling fin and the other end secured to the circuit board, so as to mount the cooling fin on the circuit board instead of on the power chip. Thus, it is not required to have a mounting hole on the power chip for mounting the cooling fin, thereby allowing the area of the second surface to be equal to or greater than the area of the first surface, ensuring full contact between the entire first surface and the second surface. In this way, the contact area between the first surface and the second surface is enlarged, thereby further ensuring the heat generated by the power chip to be effectively dissipated by the heat sink.

Furthermore, since the performance of the power chip is not limited or reduced, the desired performance is allowed to be achieved by one power chip without using two or more power chips. Thus, the overall volume and weight and thus the manufacture cost of the electronic assembly including the power chip are allowed to be reduced. Further, comparing to the electronic assembly achieving the desired performance by two or more power chips, the volume of the electronic assembly according to the disclosure is reduced by about 25%, which meets the trend of miniaturization of the electronic products and enhances the flexibility of space utilization thereof.

Also, conventional power chip is in the type of dual in-line package (DIP) and thus has a heat dissipation surface facing the circuit board. In contrary, the power chip of the disclosure has the first surface facing away from the circuit board and thus is allowed to be mounted to the circuit board by SMT, thereby saving the time for assembling the power chip and the circuit board and facilitating the assembly of the same.

In addition, the thermally conductive components and the thermally conductive layers provide an additional heat dissipation path for the heat sink. That is, besides the cooling fin, the heat sink may also dissipate the heat by transferring it to the thermally conductive layers of the circuit board via the thermally conductive components, which more effectively cools the power chip.

Moreover, the thermally conductive component further improves the heat transferring efficiency between the first surface and the second surface, which allows the heat sink to more effectively cool the power chip.

It will be apparent to those skilled in the art that various modifications and variations can be made to the present disclosure. It is intended that the specification and examples be considered as exemplary embodiments only, with a scope of the disclosure being indicated by the following claims and their equivalents.

## Claims

1. An electronic assembly (10, 10a), comprising:
a circuit board (100, 100a);
a power chip (200, 200a), disposed on the circuit board and having a first surface (231) facing away from the circuit board; and
a heat sink (300), comprising a cooling fin (310) and at least one joint part (320), wherein the cooling fin (310) comprises a second surface (311) thermally coupled to the first surface (231), an area of the second surface (311) is equal to or greater than an area of the first surface (231), ensuring full contact between the entire first surface and the second surface, the power chip (200, 200a) is positioned between the cooling fin (310) and the circuit board (100, 100a), and at least one joint part (320) has an end secured to the cooling fin (310) and the other end secured to the circuit board (100, 100a).

2. The electronic assembly according to claim 1, wherein the at least one joint part comprises a connecting part (321) and a mounted part (322), the connecting part connects the cooling fin and the mounted part, an extension direction (E1) of the connecting part and an extension direction (E2) of the mounted part are non-parallel, and the mounted part is fixed to the circuit board.

3. The electronic assembly according to claim 2, wherein the at least one joint part comprises two joint parts, and the two connecting parts of the two joint parts are connected to two opposite side of the cooling fin, respectively.

4. The electronic assembly according to claim 2, wherein the at least one joint part further comprises at least one fastened part (323), the mounted part has at least one fastening hole (324), and the at least one fastened part is fastened in the fastening hole and disposed on the circuit board.

5. The electronic assembly according to claim 4, wherein the at least one fastened part comprises a plurality of fastened parts, the at least one fastening hole comprises a plurality of fastening holes spaced apart from each other, and the plurality of fastened parts are respectively fastened in the plurality of fastening holes and disposed on the circuit board.

6. The electronic assembly according to claim 2, wherein the extension direction of the connecting part and the extension direction of the mounted part are perpendicular to each other.

7. The electronic assembly according to claim 2, further comprising at least one thermally conductive component (400a), wherein the circuit board (100a) has at least one thermally conductive layer (1 10a), and the mounted part is thermally coupled to the at least one thermally conductive layer of the circuit board via the at least one thermally conductive component.

8. The electronic assembly according to claim 7, wherein the at least one thermally conductive component is a thermal paste and is positioned between the mounted part and the circuit board.

9. The electronic assembly according to claim 1, wherein the power chip comprises a chip body (210) and a plurality of leads (220), and the plurality of leads protrude from an identical side of the chip body.

10. The electronic assembly according to claim 9, wherein the power chip further comprises a heat dissipation sheet (230), the heat dissipation sheet is disposed on the chip body, and the first surface is positioned on the heat dissipation sheet.
